# EUROPEAN PATENT SPECIFICATION

(11) **EP 2 876 184 B1**
(45) Date of publication and mention of the grant of the patent: **14.02.2018**
(21) Application number: 13005498.4
(22) Date of filing: 26.11.2013
(51) Int. Cl.: C23C 14/00, C23C 14/06, C23C 14/34, C23C 28/00, B21D 22/02, B21D 37/16, C21D 1/673

(54) **Use of a coated hot forming tool with a hard coating comprising a-C:H:W hard layer system for enhancing performance**
Verwendung eines beschichteten Heißumformwerkzeuges enthaltend ein a-C:H:W Hartschichtsystem zur Leistungsverbesserung
Utilisation d'un outil de formage à chaud revêtu comprenant un système de revêtement dur a-C: H: W pour une performance améliorée

(43) Date of publication of application: 27.05.2015
(73) Proprietor: Oerlikon Surface Solutions AG, Pfäffikon, 8808 Pfäffikon (CH)
(72) Inventor: Sobiech, Matthias Lukas, 88142 Wasserburg (DE)
(74) Representative: Kempkens, Anke

(56) References cited:
- WO-A1-2012/104048
- CLARYSSE ET AL: "Tribological properties of PVD tool coatings in forming operations of steel sheet", WEAR, ELSEVIER SEQUOIA, LAUSANNE, CH, vol. 264, no. 5-6, 2 January 2008 (2008-01-02), pages 400-404, XP022406014, ISSN: 0043-1648, DOI: 10.1016/J.WEAR.2006.08.031
- GHARAM A A ET AL: "High temperature tribological behaviour of carbon based (B4C and DLC) coatings in sliding contact with aluminum", THIN SOLID FILMS, ELSEVIER-SEQUOIA S.A. LAUSANNE, CH, vol. 519, no. 5, 30 December 2010 (2010-12-30), pages 1611-1617, XP027544676, ISSN: 0040-6090 [retrieved on 2010-08-16]
- "BALINIT guarantees superb results in punching and forming", , 4 October 2010 (2010-10-04), XP055112233, Retrieved from the Internet: URL:http://www.oerlikonbalzerscoating.com/ bmx/documents/HQ043EN.pdf [retrieved on 2014-04-04]
- ASTRID GIES ET AL: "Influence of the coating structure of a-C:H:W coatings on their wear-performance: A theoretical approach and its practical confirmation", SURFACE AND COATINGS TECHNOLOGY, vol. 237, 3 August 2013 (2013-08-03), pages 299-304, XP055113929, ISSN: 0257-8972, DOI: 10.1016/j.surfcoat.2013.07.065
- OLLE WÄNSTRAND ET AL: "Mechanical and tribological evaluation of PVD WC/C coatings", SURFACE AND COATINGS TECHNOLOGY, vol. 111, 29 January 1999 (1999-01-29), pages 247-254, XP055111763,
- BEWILOGUA K ET AL: "STRUCTURE, PROPERTIES AND APPLICATIONS OF DIAMOND-LIKE CARBON COATINGS PREPARED BY REACTIVE MAGNETRON SPUTTERING", ZEITSCHRIFT FUR METALLKUNDE, CARL HANSER, MUNICH, DE, vol. 96, no. 9, 1 September 2005 (2005-09-01), pages 998-1004, XP001234905, ISSN: 0044-3093
- Peter P Alexander Greger Norman Janiak Kaplan Wiklund ET AL: "Comparison of 22MnB5-steel with and without AlSi-coating during laser hybrid arc welding", 13th NOLAMP Conference, 27 June 2011 (2011-06-27), XP055113923, Retrieved from the Internet: URL:http://pure.ltu.se/portal/sv/publicati ons/comparison-of-22mnb5steel-with-and-wit hout-alsicoating-during-laser-hybrid-arc-w elding(6484da26-5cc8-4a4d-a396-71c2075c000 d).html [retrieved on 2014-04-14]
- KARBASIAN H ET AL: "A review on hot stamping", JOURNAL OF MATERIALS PROCESSING TECHNOLOGY, ELSEVIER, NL, vol. 210, no. 15, 19 November 2010 (2010-11-19), pages 2103-2118, XP027378020, ISSN: 0924-0136 [retrieved on 2010-08-06]
- STAVLID N: "On the Formation of Low-Friction Tribofilms in Me-DLC-Steel Sliding Contacts", DISSERTATION,, 1 January 2006 (2006-01-01), pages 9-50, XP008109434,

## Description

The present invention relates to the use of a hot forming tool coated with a hard coating comprising a-C:H:W hard layer for attaining enhanced tool life time and performance.

### State of the art

In recent years hot stamping of ultra-high strength steel sheets (as e.g. 22MnB5) is used more and more for manufacturing of automobile components (as e.g. B-pillar) with reduced weight in order to decrease on the one hand CO₂ emission but also to improve on the other hand simultaneously passenger safety. Thus structural components (as e.g. B-pillar) made of the ultra-high strength steel sheets can be made significantly lighter by simply reducing the sheet thickness. For these reasons, the application of hot stamping or hot sheet metal forming processes for manufacturing of new structural automobile components has increased considerably in recent years and therefore it is necessary to bring into focus the complications which arise in parallel as well.
In Europe for example a hot metal sheet forming method called die quenching, hot forming, hot stamping or hot pressing is employed for fabricating automobile structural components having a tensile strength of around 1500 MPa (after processing). By this method the pre-heated (up to about 950°C for homogeneous austenitization) ultra-high strength steel sheets can be easily formed and hardened in A heated ultra-high strength steel sheet is extracted from a heating furnace, then transferred within a few seconds to a pressing machine, subsequently formed into a prescribed shape using dedicated hot metal sheet forming tools which are maintained at room temperature and thus by quenching the ultra-high strength steel sheets during forming it can be hardened by the phase transformation from austenite to martensite exhibiting finally a tensile strength of about 1500 MPa. The press is kept closed for several seconds until the martensite transformation is completed (Senuma, T.: ISIJ Int. 41, 520 (2001)),

Generally speaking, as the tensile strength of a steel sheet increases, its formability and ductility decreases. Therefore, to overcome these limitations, various types of ultra-high strength steel sheet products have been developed and are still a matter of on-going research (Senuma, T.: ISIJ Int. 41, 520 (2001); 8. Erlanger Workshop Warmblechumformung Nov. 122013).

In order to protect the steel sheet surface from uncontrolled oxidation (i.e. scale formation) during heating up to about 950°C in ambient atmosphere, protective topcoats are frequently employed as e.g. AlSi- or Zn-based coatings (J. Kondratiuk et al. Wear 270 (2011) 839). For this purpose aluminized steel sheets such as the so-called USIBOR 1500 (AlSi-coated) as well as different kinds of metal sheets coated with zinc based coatings have been developed. These metal sheet variants exhibit generally excellent hot-pressing properties and corrosion resistance quality.

However, in spite of the very promising properties exhibited by the coated (AlSi and Zn) metal sheet versions as mentioned above, there are serious process complications which can be described as follows: Both sheet coating materials (AISi and Zn) exhibit at high temperatures very pronounced tendency to adhere (stick) onto the forming tool surface. After several successive forming cycles the adhered and accumulated material may result in scratches and eventually cracks (this problem is often called galling) on the surface of the formed products (e.g. B-pillar) and therefore may also result in reduced or unsatisfactory product quality. Furthermore, massive sticking of material onto the forming tool surface leads to frequent maintenance periods (cleaning of tool surface) in production environment which reduces productivity enormously. Moreover, oxidation of AlSi and Zn leads to formation of abrasive oxide phases. Thus, in direct contact with the tool surface and upon long-term operation abrasive wear becomes more and more relevant Additionally, with particular relevance for Zn-coated metal sheets, the formation of micro-cracks upon forming is also of paramount significance with respect to corrosion performance.

In order to overcome these complications it has already been speculated that process lubrication might be useful to suppress galling for AlSi-coated and Zn-coated sheets but also to reduce the degree of micro-cracking, in particular for Zn-coated sheets. However, from an industrial point of view efficient process lubrication by solid or liquid agents is not possible as it would deteriorate massively the workshop environment and upon post-treatment of the formed parts unhealthy degreasing agents would be needed in order to remove the remnants of the lubricant from the surface of the formed parts.

In WO2012104048 it is mentioned that one concept for improving current performance by hot metal sheet forming processes using coated metal sheets is to apply a low friction/high wear resistant PVD coating on the hot metal sheet forming tool. Furthermore, WO2012104048 cited the results obtained by Clarysse et al (Clarysse, F. et al. Wear 264 (2008) 400-404) in the context of some investigations about the behavior of different coating systems in tests especially designed to assess the response of the coatings to galling. They reported that carbon-based composite layers such as DLC-type (DLC is a well-known abbreviation for referring to amorphous diamond like carbon coatings which can be also referred as a-C:H coatings if they contain beside carbon only hydrogen without any further elements) and WC/C (a WC/C coating is an a-C:H:W coating in the context of the present description) perform outstanding regarding galling resistance and they recommended therefore to use this type of tool coatings instead of typical hard coatings like for example CrN, TiN and CrN/TiCrN for avoiding galling.
For better understanding of the state of the art, it is important to emphasize that the temperature at which Clarysse et al. performed the tests was not specified. However, according to the description of the experiments it is straightforward to conclude that the intention of Clarysse et al. was to investigate the behaviour of coatings with respect to cold metal sheet forming operations and not with respect to hot metal sheet forming operations.
The authors of WO2012104048 reported that the improved performance for cold metal sheet forming tools obtained by using the coatings proposed by Clarysse et al. is not given sufficiently for hot sheet metal forming processes of coated ultra-high strength metal sheets.
Furthermore, it is reported in WO2012104048 that when AlSi-coated ultra-high strength steel sheets like USIBOR 1500 are used, the galling phenomenon cannot be satisfactorily reduced and because of that galling wear continues being a problem. Additionally, the authors of WO2012104048 recommended using CrSiN coatings for Moreover, the use of nitriding and carbonitriding processes, as well as other kinds of surface treatments, such as plasma treatments and micro-structuring, is mentioned in WO2012104048 as an alternative for improving performance of hot metal sheet forming tools.

Likewise, in WO2011011129 it is mentioned that coatings which normally perform well in cold forming conditions tend to yield poor performance under warm and hot forming operations or under high contact loading conditions. The authors of WO2011011129 supposed that the low performance of the coatings in these situations can be attributed to the inability of the coating to withstand cyclic thermo-mechanical or high contact loading applications faced for example, in warm and hot forming applications. They explain that in warm and hot metal forming processes, the tooling is exposed to thermo-mechanical conditions and therefore experiences a high thermal gradient trough the thickness of the tool for example. In addition, the surface of the tooling is also subjected to cyclic thermal loading and compressive - tensile stress cycles. Consequently, the thermo-mechanical load cycle of tooling in warm and hot forming operations is also significantly different than that of tooling in cold forming operations. Additionally, WO2011011129 proposed a coating which should be able to provide improved wear life as well as oxidation resistance properties for forming tools used in thermo-mechanical load applications comprising for example TiCₓN₍₁₋ₓ₎ or TiMCₓN₍₁₋ₓ₎, with M: Al or a transition element from Groups 4, 5 and 6 of the periodic table, as a bottom coating and having a top coating including for example alumina or aluminium containing phases.

### Objective of the invention

It is an objective of the present invention, to provide a hot forming tool having improved lifetime and satisfactorily performance in hot metal sheet forming of coated metal sheets, coated with AlSi- and Zn-based coatings.

### Description of the Invention

The present invention relates to the use of a hot forming tool coated with a hard coating according to claim 1. The hot forming tool has a substrate and a hard coating, wherein the coating comprises an a-C:H:W hard layer. The hot forming tool is a hot metal sheet forming tool, whereby: an a-C:H:W hard layer is deposited as functional layer, an a-C:H:W run-in layer deposited on top of said functional a-C:H:W layer and one Cr interlayer is deposited between the substrate and the hard coating for improving the adhesion of the hard coating to the substrate. This tool is used in hot sheet metal forming processes for manufacturing a work piece, said piece being a metal sheet coated with a Zn-based or an AlSi-based coating. The work piece is an ultra-high strength metal sheet able to exhibit a tensile strength of around 1500 MPa or more after appropriate hot stamping.
Some of the a-C:H:W coatings were deposited by sputtering using an Oerlikon Balzers RS50 machine at a process temperature or substrate temperature lower than 150 °C applying a 2 fold substrate rotation. Pure chromium targets were used for sputtering deposition of a chromium interlayer as adhesion layer having a thickness of about 0.6 µm. For the deposition of the functional a-C:H:W coating with an overall thickness of about 2.4 µm four WC-containing targets were used, each target comprising about 6 % Ni in atomic percentage. The WC targets were sputtered in a mixed argon/acetylene atmosphere. The acetylene flow was higher than the argon flow for all experiments. Bias voltages under 300 V were applied at the substrates. Additionally for some experiments, on top of the functional a-C:H:W coating, a run-in a-C:H:W layer was deposited by using an_increased acetylene flow.
Coatings of the type a-C:H:W are X-ray-amorphous diamond like carbon coatings comprising beside carbon and hydrogen also tungsten; tungsten can be available in the coating at least partially as tungsten carbide (WC) embedded in the amorphous carbon hydrogen matrix (a-C:H). These type of coatings belong to the group of the metal-doped a-C:H coatings (a-C:H:Me) which are frequently employed in different tribological applications, as e.g, on movable parts in engines or gear boxes, on components in machines which are operated under high mechanical loading or on tools for forming and cutting of metallic work pieces.
Due to their outstanding properties like low friction and high wear resistance, a-C:H-W coatings are frequently used for improving performance of tools used in cold metal sheet forming operations, particularly, in order to prevent galling (material build-up) on the tool surface (see e.g. B. Podgornik et al. Surf, Coat Tech. 184 (2004) 338, P. Carlsson et al. Surf. Coat. Tech. 200 (2006) 4654, F. Clarysse et al. Wear 264 (2008) 400 and E. E. Vera et al. Wear 271 (2011) 2116).

As it was already mentioned before, the tool wear behavior in hot sheet metal forming applications (the industrially applied technology is called *hot stamping* or *press hardening* of ultra-high strength steels like 22MnB5 for production of structural automotive parts like the B-pillar) is currently confronted with severe galling phenomena, in particular when coated (e.g. AISi or Zn-based) metal sheets are used (see e.g. J. Pujante et al. CHS2 proceedings 2011 p. 377, J. Kondratiuk et al. Wear 207 (2011) 839).

Even though literature reports regarding performance of a-C:H:W coatings during hot stamping of coated metal sheets are missing, it has been stated recently in WO2012/104048A1, as already mentioned before, that a-C:H:W coatings have a rather low potential to improve tool performance during hot stamping of AlSi-coated sheets as one can read the following (see p. 3, lines 20-22): "Especially using AlSi-coated high-strength steels like USIBOR 1500 the galling phenomenon could not be satisfactorily reduced..." This conclusion is apparently directly linked to the investigations performed by F. Clarysse et al. Wear 264 (2008) 400. However, as already mentioned above, these studies are concerned with the tribological coating performance during metal sheet forming at room temperature, not with the tribological coating performance during metal sheet forming exceeding temperatures of 500°C, which is, however, the case for hot stamping processes.

Moreover, Clarysse et al. reported to have analyzed particularly an a-C:H:W coating from the company Oerlikon Balzers which is known under the product name Balinit C with the common abbreviation WC/C. The general recommendation regarding maximal service temperature is 300 C based on the argumentation that coatings of the type DLC or doped DLC (except e.g. Si-doped DLC) lose chemical and mechanical stability at temperatures above 300 C. Against this background it will be commonly assumed that such coatings are not suitable for hot metal forming operations at which the coatings are exposed to temperatures above 500 C, even though such coatings can be very useful for cold metal forming operations
However, the inventor was very curious to assess the real coating performance in order to understand in more detail why a-C:H:W coatings are not suitable for hot metal forming applications.
For the experiments the inventor decided to test a-C:H:W coatings such as the WC/C coating from the company Oerlikon Balzers produced under the name Balinit C.
High temperature tribological investigations against coated (AISi and Zn-based) ultra-high strength steels (22MnB5) were done in order to provide a sound basis for the assessment of abrasive and adhesive wear behavior of the a-C:H:W coatings. Well-established AlCrN coatings as well as substrates whose surface was submitted to plasma nitriding processes (here on top a compound layer consisting of Fe-N with a thickness of about 10 um was formed; in the following the compound layer will be abbreviated with CL) were used as reference for the comparative analysis.

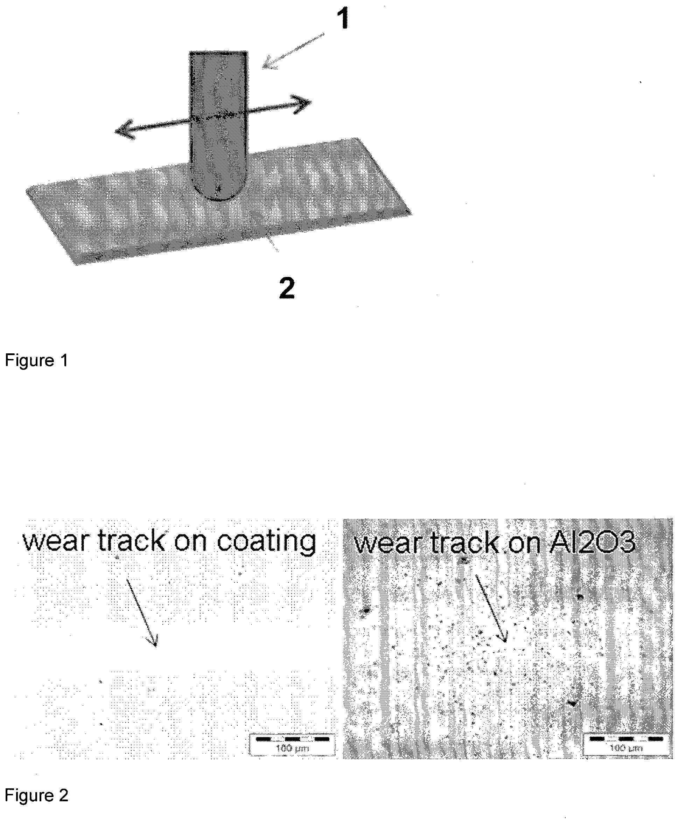

A high temperature reciprocating wear test (HT-SRV, Optimol Instruments GmbH) was employed for allowing an efficient tribological coating characterization in laboratory environment (a drawing of the test setup is shown in Fig. 1).

The lower part of the test consists of a coated metal sheet 2 (AlSi- or Zn-coated 22MnB5) which was first heated up to 900°C for AlSi-coated 22MnB5 sheets or 880°C for Zn-coated 22MnB5 sheets, respectively. A heating cartridge positioned under the metal sheet was used for heating. The temperature was subsequently hold constant for about 10 min and after that, the metal sheet was cooled down to 600°C for AlSi-coated 22MnB5 sheets or 700°C for Zn-coated 22MnB5 sheets, respectively. Shortly prior to the onset of the tribological test, the upper part of the test which consists of a coated SRV-Pin 1 was mounted into the device as well, loaded with 10N onto the surface of the lower part and was put in reciprocated sliding motion at a frequency of 1Hz during 2.5 min (covering a displacement distance of several millimeters).

In order to get more information about the wear behavior of the coating as function of testing time, the same 2.5 min test routine was repeated 10 times in succession by using for each test a new (unused) metal sheet but keeping the coated SRV-Pin unchanged.

After tribological testing the coated SRV-Pin was transferred to the scanning electron microscope (SEM) and the wear track was characterized with particular focus on the material build-up behavior (i.e. adhesive wear). A subjective classification from 1 to 5 was used in order to assess the adhesive wear, where 1 corresponds to "no build-up" and 5 corresponds to "very significant build-up".

In addition, the abrasive wear was determined quantitatively by measuring the coating thickness (by calotte grinding method) outside as well as inside the wear track. Thus, it was possible to obtain the abrasive wear in % normalized to a coating thickness of 8 µm. Relevant coating properties of the examined surfaces (coated and nitrided surfaces; nitrided with compound layer CL) are summarized in Tab. 1.

**Table 1: Summary of particularly relevant coating properties**

| | Coating thickhess in µm | Abrasive wear coefficient at RT [m³m⁻¹N⁻¹10⁻¹⁵] | Coating hardness GPa | Coefficient of friction Al₂O₃ at RT | Oxidation at 600°C for 1h in ambient atmosphere |
|---|---|---|---|---|---|
| Nitrided CL | ∼ 10 µm (CL) | 27.0 | 10 +/- 0.7 | 0.8 | 30% |
| AlCrN | ∼ 3 µm | 1.6 | 39 +/- 5 | 0.6 | 0% |
| a-C:H:W | ∼ 3 µm | 3.5 | 15 +/- 2 | 0.1 | 5% |

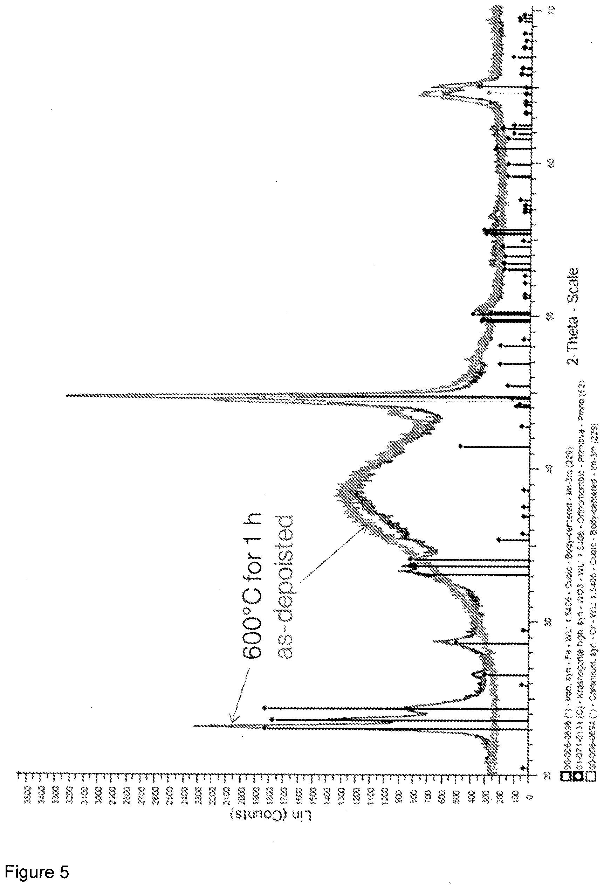

The tested a-C:H:W coatings had an overall coating thickness of about 3 µm. A pure chromium ayer was deposited as adhesion layer between the substrate surface and the functional a-C:H:W layer in order to attain better coating adhesion. The a-C:H:W coatings exhibited an amorphous X-ray spectrum as it is shown in Fig. 5.
The abrasive wear resistance of the a-C:H:W coatings examined at RT (room temperature) against Al₂O₃ was significantly higher as compared with the nitrided-CL substrates but similarly good as compared with the AICrN coatings.
The tested a-C:H:W coatings having overall hardness of about 10 GPa as well as of about 15 GPa, were examined. Particularly, a-C:H:W coatings exhibiting rather moderate coating hardness of about 15 GPa showed better wear behavior.

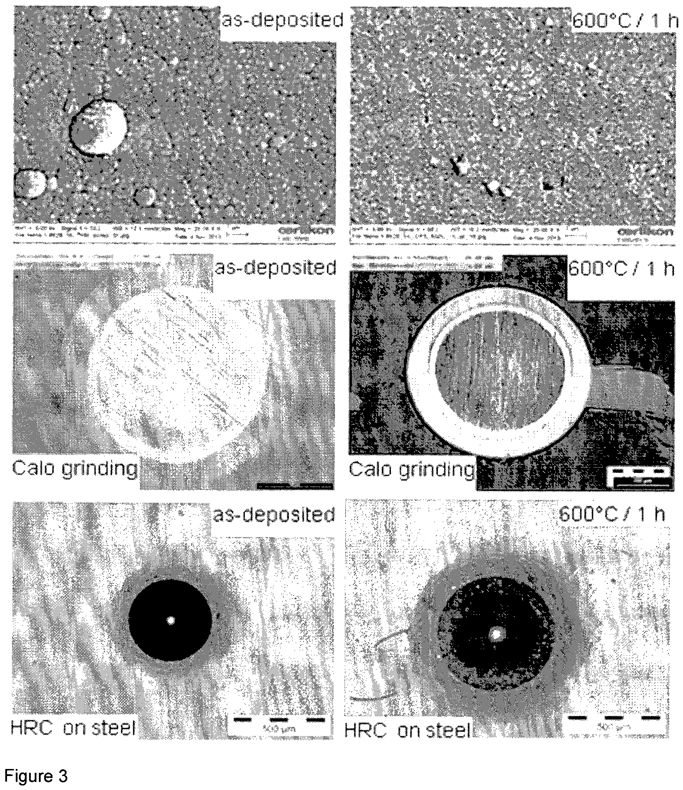

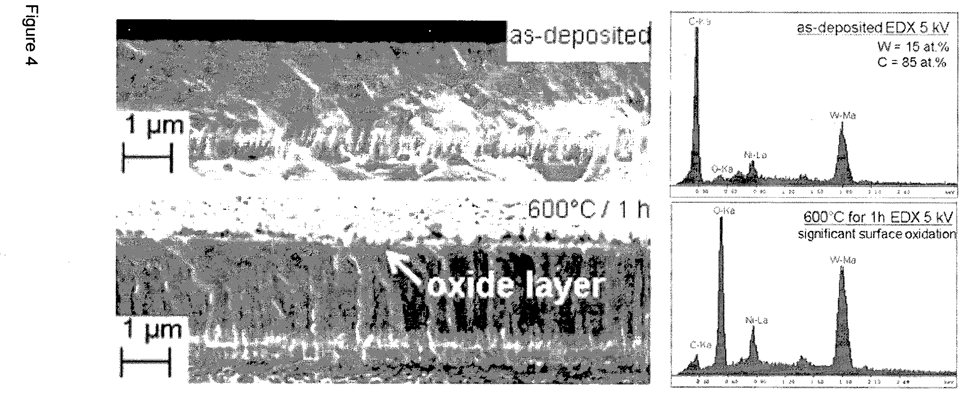

The friction behavior at RT against Al₂O₃ in dry conditions was characterized by an outstanding coefficient of friction of about 0.1 .
The wear track on the coating surface as well as the wear track on the Al₂O₃ ball demonstrates the superior tribological performance (see Fig. 2).
Furthermore, in order to assess the high temperature performance in ambient atmosphere regarding structural and chemical stability, annealing experiments at 600°C for 1 hour in ambient atmosphere were done. The results regarding oxidation behavior (i.e. formation of oxide layer thickness as measured in cross-sectional SEM analyses) are shown in Tab. 1 in % normalized to a coating thickness of 8 µm. The a-C:H:W coatings showed good oxidation resistance at 600 °C for 1 h as compared with nitrided-CL substrates, whereas AlCrN coatings were fully free of any oxidation. After annealing at 600 °C for 1 h the surface of the tested a-C:H:W coatings exhibited clearly visible microstructural changes (see SEM images shown in Fig. 3).
Cross-sectional SEM micrographs (see Fig. 4 left) revealed the formation of an oxide layer with a thickness in the range of some hundreds of nanometers and top-view EDX analyses with 5 kV acceleration voltage confirmed that the oxide layer consist predominantly of tungsten and oxygen (see Fig. 4 right). Finally by means of XRD it was unequivocally possible to show that the oxide layer is composed of crystalline orthorhombic WO₃ (see Fig. 5).
Additionally to the oxidation behavior at 600 °C for 1 h, it was possible to demonstrate by the annealing experiments that tested a-C:H:W coatings exhibit good structural stability at these annealing conditions. The Calo grinding (see Fig. 3), the cross-sectional SEM micrograph (see Fig. 4 left) as well as the HRC indent (see Fig. 5) after annealing at 600°C for 1 h showed clearly that the coating is preserved (some minor microstructural modifications are visible) still exhibiting excellent coating adhesion.

Moreover, the comparison of the XRD pattern taken before and after annealing Indicates that the "amorphous hump" originating from the "X-ray amorphous" a-C:H:W coatings is more or less unaffected, i.e. the structure of a-C:H:W coatings was not significantly changed upon annealing.

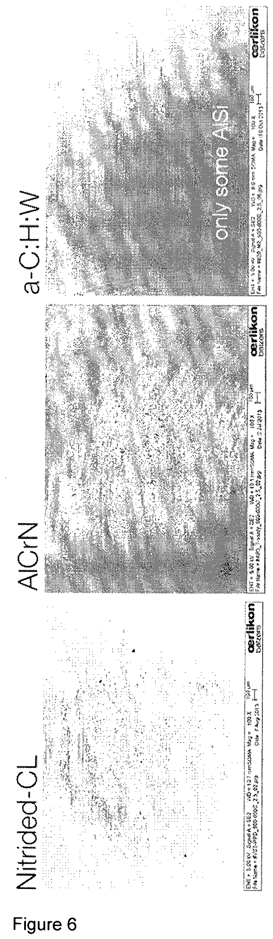

The results of the HT-SRV test for the tribosystem coating vs. AlSi/22MnB5 are shown in Tab. 2 and Fig. 6. Adhesive wear was evaluated with the number 1 as the best behavior and with the number 5 as the worst behavior; abrasive wear was reported as coating loss in % normalized to 8 µm. The coefficient of friction (COF) was measured as well.

**Table 2: Results obtained after HT-SRV testing for the tribosystem involving coating vs. AlSi/22MnB5. Adhesive wear: 1 best and 5 worst; Abrasive wear: coating loss in % normalized to 8 µm**

| x = metal blank temperature | HT-SRV-Testing x = 600°C, 1 x 2.5min | | HT-SRV-Testing x = 600°C, 10 x 2.5min | | COF at 600°C vs. sheet |
|---|---|---|---|---|---|
| | Abrasion | Adhesion | Abrasion | Adhesion | |
| Nitrided-CL | 10% | 1.5 | 20% | 2.5 | 1.4 |
| AlCrN | 0% | 3.5 | 0% | 5.0 | 1.2 |
| a-C:H:W | 0% | 1.25 | 20% | 1-25 | 0.3 |

The tested a-C:H:W coatings showed after one 2.5 min test no abrasive as well as nearly no adhesive wear, which clearly reveals the potential of such a-C:H:W coatings for improving performance of hot metal forming tools, particularly for enhancing performance of hot metal sheet forming tools as well by improving performance of surfaces involved in hot stamping applications (see Fig. 6).

After 10 repetitions of the same 2.5 min SRV test the tested a-C:H:W coatings were still more or less free of AlSi build-up, but abrasive wear became an issue. However, the level of abrasive wear was of the same magnitude as for the industrially applied nitrided-CL surface, which can be taken as a kind of industrial reference, i.e. it can be assumed that this level of abrasive wear is acceptable.

Very striking is the significantly lower coefficient of friction (COF) for a-C:H:W measured directly during testing against A/Si/22MnB5 as compared to the benchmark. The COF is by a factor of about 4 smaller. The superior performance of a-C:H:W might be related to the significantly reduced COF.

The inventor found it very surprisingly that in spite of the widely accepted fact that a-C:H and metal doped a-C:H coatings (excepting a-C:H:Si coatings) such as a-C:H:W coatings are not useful for high temperature applications exceeding temperature of 300°C, such type of coatings can indeed be very good promising candidates for industrial hot metal forming applications such as hot stamping and hot metal sheet forming of coated ultra-high strength steels.

The tested a-C:H:W coatings showed upon ongoing testing abrasive wear behavior which is comparable to industrial benchmark, however, it is likely that the main advantage of this type of coatings against AlSi-coated sheets is that they remain nearly free of AlSi build-up upon long-term operation (upon prolonged testing).

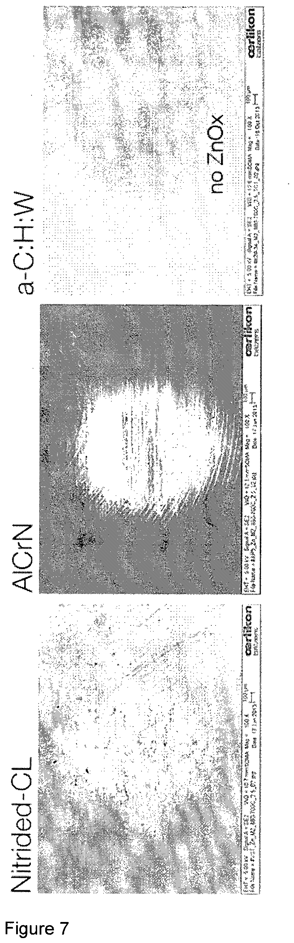

The results of the HT-SRV test for the tribosystem coating vs. Zn-based/22MnB5 are shown in Tab. 3 and Fig. 7. Adhesive wear was evaluated with numbers, the number 1 corresponding to the best and the number 5 corresponding to the worst behavior, respectively. Abrasive wear was reported as coating loss in % normalized to 8 µm. The coefficient of friction (COF) was measured as well.

**Table 3: Results obtained after HT-SRV testing for the tribosystem involving coating vs. Zn-based/22MnB5. The coefficient of friction was measured as well. Adhesive wear: 1 best and 5 worst; Abrasive wear: coating loss in % normalized to 8 µm**

| x = metal blank temperature | HT-SRV-Testing x = 700°C, 1 x 2.5min | | HT-SRV-Testing x = 700°C, 10 x 2.5min | | COF at 700°C vs. sheet |
|---|---|---|---|---|---|
| | Abrasion | Adhesion | Abrasion | Adhesion | |
| Nitrided-CL | 0%s | 3.0 | 15% | 30 | 1.4 |
| AlCrN | 0% | 3.0 | 0% | 3.5 | 1.4 |
| a-C:H:W | 0% | 1.0 | 0% | 1.0 | 0.6 |

The tested a-C:H:W coatings show after one 2.5 min test no abrasive as well as no adhesive wear and after 10 repetitions of the same 2.5 min SRV test these coatings were still absolutely free of any ZnOx build-up, and, very surprisingly, still without abrasive wear. This unexpected results clearly show that a-C:H:W coatings are particularly very promising for hot stamping or hot metal sheet forming of Zn-based coated metal sheets.

Also very striking is the significantly lower coefficient of friction (COF) for a-C:H:W measured directly during testing against Zn/22MnB5 as compared to the benchmark. The COF Is by a factor of about 2 smaller. The superior performance of a-C:H:W might be related to the significantly reduced COF. As mentioned before, it has already been speculated that process lubrication might be useful to reduce the degree of micro-cracking in particular for Zn-coated sheets. Therefore the reduced COF of a-C:H:W might indeed be relevant for optimized manufacturing of Zn-coated metal sheets where the formation of micro-cracks upon forming is of paramount significance.

### Figure captions

- Figure. 1: HT-SRV test setup.
- Figure 2: Wear tracks on a-C.H:W coatings and counter body (Al₂O₃ ball) after tribological ball on disc test.
- Figure 3: SEM top-view micrographs, Calo grindings and HRC indents on the as-deposited and the annealed (600 °C for 1 h) specimens.
- Figure 4: Cross-sectional (fracture) SEM micrographs (left) and top-view EDX spectra with 5 kV acceleration voltage (right) of the as-deposited and the annealed specimens.
- Figure 5: XRD pattern taken before and after annealing at 600°C for 1h.
- Figure 6: SEM micrographs of the wear tracks after 2.5 min testing at 600 °C for tribosystem coating vs. AlSi/22MnB5. Build-up material is AlSi-based.
- Figure 7: SEM micrographs of the wear tracks after 2.5 min testing at 700 °C for tribosystem coating vs. Zn-based/22MnB5. Build-up material is ZnOx-based.

## Claims

1. Use of a coated forming tool having a substrate and a hard coating, the hard coating comprising a chromium layer as adhesion layer, an a-C:H:W hard layer deposited as functional layer and an a-C:H:W run-in layer deposited on top of said functional a-C:H:W hard layer, wherein the coated forming tool is used as a hot metal sheet forming tool for a hot metal sheet forming process, in which a metal sheet coated with a Zn-based coating or a metal sheet coated with an AlSi-based coating is processed, wherein the coated metal sheet that is processed is an ultra-high strength metal sheet, and wherein the ultra-high strength metal sheet is a metal sheet of the type 22MnB5.

## Patentansprüche

1. Verwendung eines beschichteten Umformwerkzeugs mit einem Substrat und einer Hartbeschichtung, wobei die Hartbeschichtung eine Chromschicht als Haftschicht, eine als Funktionsschicht abgeschiedene a-C:H:W-Hartschicht und eine a-C:H:W-Einlaufschicht umfasst, die auf dieser funktionellen a-C:H:W-Hartschicht abgeschieden wird, wobei das beschichtete Umformwerkzeug als Heißumformwerkzeug für Metallplatten für ein Heißumformverfahren für Metallplatten verwendet wird, in welchem eine mit einer Zn-basierten Beschichtung beschichtete Metallplatte oder eine mit einer AlSi-basierten Beschichtung beschichtete Metallplatte verarbeitet wird, wobei die beschichtete Metallplatte, die verarbeitet wird, eine höchstfeste Metallplatte ist, und wobei die höchstfeste Metallplatte eine Metallplatte des Typs 22MnB5 ist.

## Revendications

1. Utilisation d'un outil de déformation revêtu ayant un substrat et un revêtement dur, le revêtement dur comprenant une couche de chrome comme couche d'adhésion, une couche a-C:H:W dure déposée comme couche fonctionnelle et une couche a-C:H:W de rodage déposée sur ladite couche a-C:H:W dure et foncitionnelle, l'outil de déformation revêtu étant utilisé comme outil de déformation à chaud pour les plaques métalliques pour un processus de déformation à chaud pour les plaques métalliques, dans lequel une plaque métallique revêtue d'un revêtement à base de Zn ou une plaque métallique revêtue d'un revêtement à base de AISi est traitée, la plaque métallique revêtue, qui est traitée, étant une plaque métallique à très haute résistance, et la plaque métallique à très haute résistance étant une plaque métallique du type 22MnB5.
